# EUROPÄISCHE PATENTSCHRIFT

(11) **EP 2 329 319 B1**
(45) Veröffentlichungstag und Bekanntmachung des Hinweises auf die Patenterteilung: **17.07.2013**
(21) Anmeldenummer: 09782221.7
(22) Anmeldetag: 26.08.2009
(51) Int. Cl.: G03F 7/00

(54) **VERBESSERTES NANOIMPRINT-VERFAHREN**
IMPROVED NANOIMPRINT METHOD
PROCÉDÉ AMÉLIORÉ DE NANO-IMPRESSION

(30) Priorität: 27.08.2008 DE 102008041623
(43) Veröffentlichungstag der Anmeldung: 08.06.2011
(73) Patentinhaber: AMO GMBH, 52074 Aachen (DE)
(72) Erfinder: KOO, Namil, 52074 Aachen (DE); KIM, Jung Wuk, 52064 Aachen (DE); MOORMANN, Christian, 52074 Aachen (DE)
(74) Vertreter: Bauer, Wulf
(86) Internationale Anmeldenummer: PCT/EP2009/061005
(87) Internationale Veröffentlichungsnummer: WO 2010/023227

(56) Entgegenhaltungen:
- EP-A- 1 473 594
- EP-A- 1 972 997
- WO-A-2006/062930
- WO-A-2008/124180
- WO-A-2008/156750
- US-A1- 2004 149 683
- US-A1- 2004 231 781
- US-B1- 6 180 239
- TAN HUA ET AL: "Roller nanoimprint lithography" JOURNAL OF VACUUM SCIENCE & TECHNOLOGY B: MICROELECTRONICSPROCESSING AND PHENOMENA, AMERICAN VACUUM SOCIETY, NEW YORK, NY, US, Bd. 16, Nr. 6, 1. November 1998 (1998-11-01), Seiten 3926-3928, XP012007312 ISSN: 0734-211X

## Beschreibung

Die vorliegende Erfindung betrifft ein Verfahren nach dem Oberbegriff des Patentanspruchs 1. Ein derartiges Verfahren ist aus der WO 2006/062930 bekannt. Die Forderung, Strukturen im Nano- oder Mikrobereich schnell, ökonomisch und reproduzierbar herzustellen, ist eine der Hauptmotivationen bei der Entwicklung der Nanotechnologie.

Ein kostengünstiges Verfahren ist die sogenannte Nanoimprint, eine junge Lithographietechnologie zur Fabrikation nanoskaliger Strukturen im Bereich der Nanoelektronik, Photonik und Biotechnologie. Die grundlegende Idee ist die Replikation von Strukturen, welche in einen Stempel eingebracht, beispielsweise geätzt, wurden, durch das Eindrücken dieser strukturierten Stempeloberfläche in einen aushärtbaren, fließfähigen Resist mit geringer Viskosität auf einer Substratoberfläche, d.h. durch gleichzeitiges Prägen des Resists und Aufbringen (Bedrucken) des Substrats. Nach dem Auffüllen aller Hohlräume der strukturierten Stempeloberfläche mit dem Resist wird mittels Wärme und/oder UV-Licht die Lackschicht ausgehärtet. Im letzten Schritt wird der Stempel entfernt und es verbleibt eine 3-dimensionale Replikation der Struktur in der Resistbeschichtung auf dem Substrat. Durch weiteres Ätzen kann die Nanostruktur dann in ein Substrat übertragen werden. Das Verfahren wird beispielsweise in der US 2007059497 A1 beschrieben.

Es sind unterschiedliche Verfahren bekannt, die noch zu prägende Resistbeschichtung auf die Stempeloberfläche oder auf das Substrat aufzubringen. In der zuvor genannten US 2007059497 A1 wird dies dadurch erreicht, dass das Resist mittels Rotationsbeschichtung auf die strukturierte Stempeloberfläche aufgebracht wird. In der US 6334960 B1 wird die Dispensierung von Resistlacktropfen auf das Substrat beschrieben, um dann mittels der strukturierten Stempeloberfläche die Resistoberfläche auf dem Substrat zu prägen. Die Dispensierung ist vergleichsweise zeitaufwendig und die Resisttropfengrenzen können zu Defekten in dem geprägten Resist nach der Aushärtung führen.

Aus der US 5425848 A1 ist ein walzenförmiger Stempel mit strukturierter Walzenoberfläche bekannt, der auf dem mit einer Resistbeschichtung versehenen Substrat abrollt, um die Resistbeschichtung zu prägen. Die Resistbeschichtung wird durch eine UV-Bestrahlung im Bereich des Walzenspaltes nahezu gleichzeitig ausgehärtet.

Aus der WO 02/03142 A2 ist ein Verfahren bekannt, bei dem ein Polydimethylsiloxan-Stempel mit einer organischen Flüssigkeit benetzt wird, um auf dessen Oberfläche selbstanordnende Monoschichten (self assembled monolaysers =SAMs) auszubilden, und bei dem der Stempel mit den SAMs auf das Substrat gedrückt wird, um die SAMs auf das Substrat zu übertragen.

Beim Nanoimprint des Standes der Technik ist man mit zwei Problemen bzw. Zielen konfrontiert, einerseits eine gleichmäßige homogene Ausfüllung der strukturierten Stempeloberf-läche zu erreichen, andererseits sollte der Resist, wie nachfolgend erläutert wird, möglichst dünn aufgetragen werden, um die nachfolgende Ätzbehandlung des Substrats nicht zu verzögern oder zu beeinträchtigen.

Diese Ziele konkurrieren, da die gleichmäßige Auffüllung üblicherweise mit einer überschüssigen Menge an Resist erreicht wird, verbleibt immer eine nicht strukturierte Resist (Dicke des ausgehärteten Resists unterhalb der Struktur), die zusätzlich Schichtdickeninhomogenität aufweisen kann, Ist die Struktur der Stempeloberfläche nicht periodisch sondern unregelmäßig, so kann diese Inhomogenität noch größer werden, da bei der Füllung von größeren Volumen der Struktur mehr Resist zur Füllung verbraucht wird als bei kleineren Strukturvolumen, so dass es zu Lackmangel und Auffülldefekten kommen kann. Diese Inhomogenität kann selbst bei Verwendung von Lacken mit größerer Viskosität zwar reduziert werden, indem Lack mit größerer Lackdicke, also eine dickere Lackschicht, zur Füllung der Struktur verwendet wird. Die Verwendung eines solchen Lacks erschwert jedoch den anschließenden Ätzvorgang zur Strukturübertragung ins Substrat, wie er üblicherweise in der Halbleiterindustrie zur Anwendung kommt.

Zur Reduzierung der Inhomogenität kann zwar höherer Druck beim Prägen angewendet werden, dies funktioniert jedoch nicht bei flexiblen Stempeln und sorgt darüber hinaus in der Regel nur für eine minimale Verringerung der Restresistdicke.

Zur Steigerung der Homogenität bei gleichzeitiger Minimierung der Restresist decke is es bekannt den Vorgang der Beschichtung an die Struktur angepasst vor zunehmen, indem bei der Tropfendispensierung die Dichte und Größe der Tropfen lokal an die Struktur adaptiert werden. Dies erfordert eine genaue Analyse der Struktur und ist daher vergleichsweise aufwendig und zeitintensiv. Der apparative Aufbau ist vergleichsweise kompliziert, und es bleibt das zuvor erwähnte Problem von Defekten an den Resisttropfengrenzen bestehen.

Der Erfindung liegt daher die Aufgabe zugrunde, ein Verfahren zur Aufbringung einer strukturierten Beschichtung aus Resist auf eine Substratoberfläche mit einer gegenüber dem Stand der Technik dahingehend verbesserten Resistbeschichtung bereitzustellen, dass diese homogener ist und eine geringere Restresistdicke aufweist und das Verfahren einfach schnell und kostengünstig durchgeführt werden kann.

Diese Aufgabe wird durch ein Verfahren des Anspruchs 1 gelöst. Vorteilhafte Ausgestaltungen sind jeweils Gegenstand der abhängigen Ansprüche. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung, insbesondere im Zusammenhang mit den Figuren, charakterisiert und spezifiziert die Erfindung zusätzlich.

Die Erfindung betrifft ein Verfahren zur Aufbringung einer strukturierten Beschichtung aus Resist auf eine Substratoberfläche. Das Verfahren umfasst wenigstens einen Prägeschritt, bei dem fließfähiges Resist jeweils zwischen einer strukturierten Oberfläche eines Stempels und einem Träger geprägt wird, um dem fließfähigen Resist eine strukturierte Oberfläche zu verleihen, die der der Stempeloberfläche entspricht. Das Verfahren umfasst jeweils einen nachfolgenden Trennschritt, bei dem der Stempel mit der strukturierten Resistbeschichtung aus dem noch nicht ausgehärteten Resist und der Träger voneinander getrennt werden. Durch die Trennung des Stempels mit einem ersten Teil der strukturierten Resistbeschichtung und der Träger mit einem zweiten Teil der Resistbeschichtung wird somit die an die Stempeloberfläche angrenzende Resistbeschichtung entlang einer zur Stempeloberfläche parallelen Schnittlinie in zwei Teile unterteilt, wobei die Restresistdicke der auf der Stempeloberfläche nach dem Trennschritt vorhandenen Resistbeschichtung vermindert ist, beispielsweise in etwa halbiert ist.

Der Prägeschritt und der zugehörige Trennschritt werden bevorzugt je nach angestrebter Reduzierung der Restdicke der Resistbeschichtung wiederholt durchgeführt, bis die Restdicke des auf dem Stempel befindlichen ersten Teils der Resistbeschichtung sukzessive auf das gewünschte Maß verringert ist.

Das erfindungsgemäße Verfahren umfasst ferner einen nachfolgenden Transferschritt, bei dem die strukturierte Resistbeschichtung auf der Stempeloberfläche, d.h. der erste Teil, gegen die Substratoberfläche gedrückt wird, um die strukturierte Resistbeschichtung auf die Substratoberfläche zu übertragen und einen Härteschritt, bei dem der erste Teil der strukturierten Resistbeschichtung, der auf der Substratoberfläche angeordnet ist, ausgehärtet wird. Danach oder zeitlich überlappend erfolgt ein Entformungsschritt, bei dem der Stempel von dem ersten, auf dem Substrat befindlichen Teil der strukturierten Resistbeschichtung getrennt wird.

Die Erfindung ist hinsichtlich der Prozessparameter, wie Druck und Temperatur nicht eingeschränkt und diese werden entsprechend der für das Resist, das Substrat beziehungsweise den Träger ausgewählten Materialien gewählt sein; in einer Ausgestaltung erfolgt wenigstens der Prägeschritt und der Transferschritt im Vakuum. Bevorzugt erfolgen die Schritte in einer Umgebung mit einer in der ISO- 14644-1 festgelegten Konzentration luftgetragener Teilchen (Reinraumbedingung). Die Temperatur liegt beispielsweise im Bereich von etwa 30°C unterhalb bis etwa 90°C oberhalb der Glasübergangstemperatur des Resists.

Der Prägeschritt und der Transferschritt dienen somit der Übertragung der Höhen- und Breiteninformation der Stempeloberflächenstruktur auf die letztlich auf dem Substrat befindliche Resistbeschichtung.

Das erfindungsgemäße Verfahren zeichnet sich durch den oder die vorgeschalteten Sequenzen aus Präge- und Trennschritt aus, wodurch die Schichtdicke der auf das Substrat zu übertragenden Resistbeschichtung und insbesondere die Restdicke, d.h. die über die Strukturtiefe hinausgehende Dicke der Resistbeschichtung, reduziert werden können und gleichzeitig ein homogenes Auffüllen der Stempelstruktur erreicht wird. Da die Schritte des Prägens bzw. Auffüllens der Stempelstruktur, die Reduzierung der Schichtdicke durch das Trennen und das Übertragen auf das Substrat entkoppelt durchgeführt werden, können diese einfacher und jeweils separat hinsichtlich Befüllung, dünner Restschicht, Homogenisierung von Restschicht und Füllung und guter Auflösung bei der Reproduktion der Struktur optimiert werden, indem beispielsweise die Prozessbedingungen, wie Druck, Temperatur, Zeit und/oder die Oberflächenbeschaffenheit des Trägers einerseits und des Substrats andererseits in jedem Schritt separat eingestellt werden. Die Verwendung mechanischer Vorrichtungen, wie Rakel oder Doktorblade, zum teilweisen Abtragen der Beschichtung sind nicht erforderlich. Die dadurch mögliche Beschädigung der Beschichtung oder gar der Stempeloberfläche ist bei dem erfindungsgemäßen Verfahren ausgeschlossen.

Bei dem erfindungsgemäße Verfahren kann der Stempel mit dem Resist beschichtet werden, bevorzugt wird jedoch in einem dem Prägeschritt vorgeschalteten Beschichtungsschritt, der Träger mit dem fließfähigen Resist beschichtet. Da der Träger eine im Allgemeinen ebene Oberfläche ohne Strukturierung aufweist, ist eine homogene Verteilung einfacher auf dem Träger als auf der strukturierten Stempeloberfläche zu erreichen. Bevorzugt wird im Beschichtungsschritt der Träger im Schleuderverfahren mit dem fließfähigen Resist beschichtet. Dadurch wird schnell und effektiv eine homogene Verteilung des fließfähigen Resists erreicht.

Zur Verbesserung der Strukturausfüllung weist gemäß einer Ausgestaltung des erfindungsgemäßen Verfahrens der Träger im Vergleich zum Substrat eine oberflächenaktive, beispielsweise haftmindernde, Beschichtung auf oder ist aus einem entsprechenden Material hergestellt.

Bei einer weiteren bevorzugten Ausführungsform wird nach dem Trennschritt der erste, auf dem Stempel befindliche Teil der Resistbeschichtung mit einem gegenüber dem Resist wirksamen Lösungsmittel benetzt, um das Haftvermögen auf dem Substrat bei der späteren Übertragung auf dessen Oberfläche zu steigern und die Viskosität des Resists zu erniedrigen und damit die Gleichmäßigkeit der Verteilung des Resists auf der Stempeloberfläche zu verbessern. Das Lösungsmittel, beispielsweise Toluol, Xylol Tetrahydrofuran, kann insbesondere auf einer mit einer oberflächenaktiven Substanz beschichteten Stempeloberfläche für eine gleichmäßige Resistbeschichtung sorgen.

Gemäß einer weiteren, vorteilhaften Ausgestaltung des erfindungsgemäßen Verfahrens wird nach dem Trennschritt in einem Schleuderschritt der Stempel mit dem ersten Teil der strukturierten Resistbeschichtung geschleudert, um so eine noch homogenere Verteilung zu erreichen. Bevorzugt erfolgt der Schleuderschritt in Kombination mit einer vorgeschalteten Benetzung des Resists mit dem zuvor genannten Lösungsmittel.

Das Resist kann so beschaffen sein, dass ein Aushärten thermisch, d.h. durch Temperaturerhöhung erfolgt. Bevorzugt handelt es sich um ein unter UV-Licht aushärtendes Resist, wobei dann in dem Härteschritt das Resist mittels UV-Licht gehärtet wird.

Härteschritt und Transferschritt werden gemäß einer weiteren vorteilhaften Ausgestaltung gleichzeitig oder zeitlich überlappend durchgeführt. Da beim Aushärten die Bindung zum Substrat höher ist, ist es möglich, die Beschichtung rückstandsfrei vom Stempel auf das Substrat zu übertragen und auch die Form der übertragenen Struktur in allen drei Dimensionen zu kontrollieren.

Bevorzugt handelt es sich bei der Struktur der strukturierten Stempeloberfläche um eine Mikro- bis Nanostruktur. Nanostruktur im Sinne der Erfindung ist eine Struktur mit einer lateralen Auflösung von bis zu einigen nm.

Das Material des Substrats ist bevorzugt aus der Gruppe bestehend aus wenigstens einem Halbleiter, wie Silizium, GaAs, InP, wenigstens einem Dielektrika, wie Quarzglas und wenigstens einem Metall und Kombinationen daraus ausgewählt. Beispielsweise handelt es sich bei dem Substrat um einen polierten Silizium-Wafer. Die Erfindung ist aber nicht auf harte und flache Substrate beschränkt, sondern das erfindungsgemäße Verfahren eignet sich auch für die Beschichtung von flexiblen Polyimidfilmen als Substrat.

Der Begriff Resist im Sinne der Erfindung ist weit auszulegen, und es handelt sich allgemein um eine lackartige, fließfähige Substanz, die nach dem Härten eine auf das Substrat aufgebrachte Maske bildet, die für eine lokal variierende Abdeckung sorgt, so dass Strukturen in die Oberfläche des Substrats in dessen späteren Bearbeitung entsprechend der Maskierung durch die Maske eingearbeitet werden. Die Struktur, genauer die Tiefe der Struktur, wird im Allgemeinen so gewählt sein, dass die Dicke der Maske, die sich durch die strukturierte Resistbeschichtung ergibt, so gewählt ist, dass im nachfolgenden Bearbeitungsschritt (Ätzen) des Substrats eine erforderliche Mindestwiderstandsfähigkeit der Resistbeschichtung gegeben ist. Im Allgemeinen handelt es sich bei dem Resistmaterial im Vergleich zum Stempel um ein relativ weiches Material, das von einem fließfähigen in einen ausgehärteten Zustand zu überführen ist und beinhaltet Polymere, wie thermoplastische Polymere, thermisch durch Strahlung (UV-Strahlung) härtbare Prepolymere, beispielsweise PMMA oder Monomere, bevorzugt ein rein-organisches Monomer oder ein organisches/anorganisches Verbundmonomer. Beispielsweise handelt es sich um ein Methacrylat basiertes Resist. Bevorzugt beträgt die Viskosität des fließfähigen Resist weniger als 50 m Pa s.

Der Stempel des erfindungsgemäßen Verfahrens kann hart sein und ist beispielsweise aus Halbleitern, Dielektrika, Metallen und deren Kombination gebildet. Die Struktur in dessen strukturierter Oberfläche ist beispielsweise mittels Elektronenstrahllithografie und anschließendem trockenen Ätzen eingebracht. Um im Entformungsschritt die Trennung von Stempel und beschichtetem Substrat zu erleichtern, kann die Stempeloberfläche mit oberflächenaktiven Mitteln, wie 1H, 1H, 2H, 2H Perfluordecyl-trichlorsilan, behandelt sein.

Bevorzugt ist der erfindungsgemäße Stempel aus einem flexiblen Material hergestellt. Dadurch ist das Übertragen von einer Struktur auf ein Substrat mit nicht planer Oberfläche ermöglicht. Flexible Stempel weisen zudem eine sehr geringe Haftung zum Resist auf und ermöglichen ein sehr leichtes Entformen nach dem Aushärten des Resists, so dass ein hoher Durchsatz erreicht wird.

Noch bevorzugter ist der Stempel aus einem Polymer hergestellt. Dadurch wird eine einfache und kostengünstige Replikation der Struktur aus einem "Master"-Stempel ermöglicht.

Bei dem erfindungsgemäßen Verfahren wird in einer Ausgestaltung die Substratoberfläche in mehreren abfolgenden Schritten nacheinander in mehreren Transferschritten mit der strukturierten Resistoberflläche beschichtet (Step and repeat). Gemäß einer weiteren vorteilhaften Ausgestaltung sind der Träger und/oder der Stempel als Walze oder Transportband ausgebildet, um die zugehörigen Schritte des erfindungsgemäßen Verfahrens kontinuierlich durchführen zu können.

In diesen Falle sind der Träger und der Stempel als Walze oder Transportband ausgebildet und der wenigstens eine Prägeschritt mit zugehörigem Trennschritt, der Druckschritt und Entformungsschritt werden in einem kontinuierlichen Walzenach-Walze-Transferverfahren durchgeführt. Dadurch kann beispielsweise schnell und effektive eine große Substratoberfläche beschichtet werden. Durch die Entkopplung von Prägen und Übertragen der Resistbeschichtung ist keine Vorbehandlung des Substrats wie beim Stand der Technik erforderlich.

In einer weiteren vorteilhaften Ausgestaltung werden gegenüberliegende Substratoberflächen des Substrats gleichzeitig dem Transferschritt unterzogen. Durch die gleichzeitige Beschichtung gegenüberliegender Substratoberfläche kann gegenüber einer zeitlich abfolgenden Beschichtung der Durchsatz gesteigert werden.

Bei einer weiteren vorteilhaften Ausgestaltung wird in einem dem Entformungsschritt nachfolgenden Ätzschritt die mit der strukturierten Resistoberfläche beschichtete Substratoberfläche geätzt, beispielsweise anisotrophisch geätzt, um beispielsweise Komponenten für eine Mikromechanik herzustellen. Bevorzugt wird das Verfahren mit dem nachfolgenden Ätzschritt zur Herstellung einer Halbleiterstruktur, beispielsweise von nanoskaliger FinFet-Transistoren in CMOS-Technologie, verwendet, wobei nach dem Ätzschritt optional ein Dotierschritt vorgenommen werden kann.

Die Erfindung betrifft ferner eine Vorrichtung zur Durchführung des Verfahrens in einer der zuvor beschriebenen Ausgestaltungen und umfasst wenigstens einen Stempel und wenigstens einen Träger zur Prägung der Resistbeschichtung auf dem wenigstens einen Träger und wobei der Stempel der nachfolgenden Übertragung der geprägten Resistbeschichtung auf das Substrat dient.
Die Erfindung sowie das technische Umfeld werden nachfolgend anhand einer Figur näher erläutert. Es ist darauf hinzuweisen, dass die Figur eine besonders bevorzugte Ausführungsvariante der Erfindung zeigt, diese jedoch nicht darauf beschränkt ist. Es zeigen schematisch:
- **Fig. 1** den Beschichtungsschritt des erfindungsgemäßen Verfahrens;
- **Fig. 2** den Prägeschritt des erfindungsgemäßen Verfahrens;
- **Fig. 3** den Trennschritt des erfindungsgemäßen Verfahrens;
- **Fig. 4** den Transferschritt des erfindungsgemäßen Verfahrens;
- **Fig. 5** den Härteschritt des erfindungsgemäßen Verfahrens;
- **Fig. 6** den Entformungsschritt des erfindungsgemäßen Verfahrens;
- **Fig. 7** eine Vorrichtung zur Durchführung des erfindungsgemäßen Verfahrens in einer weiteren Ausführungsform.

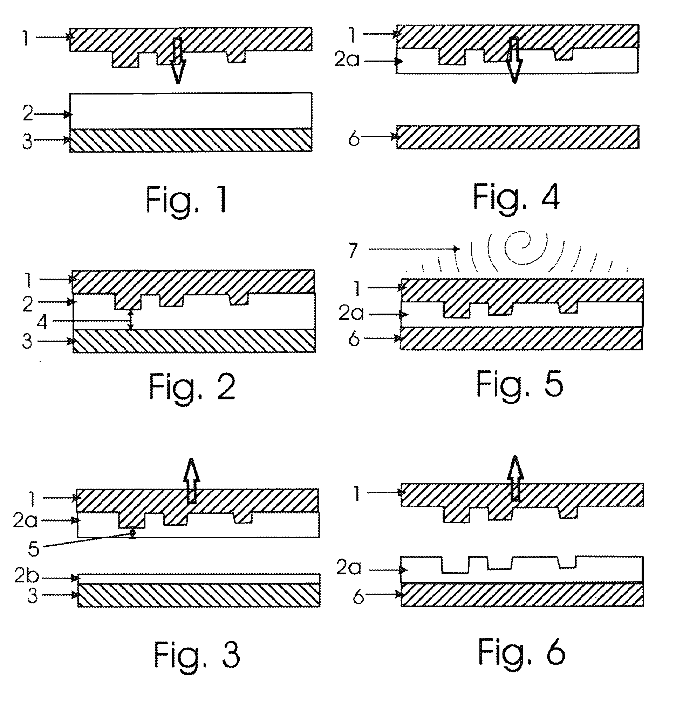

In Fig. 1 ist die Beschichtung eines Trägers 3 mit dem fließfähigen Resist 2 dargestellt. Dabei kann ein Schleuderverfahren (nicht dargestellt) zur Anwendung kommen. Ein flexibler aus Polymer hergestellter Stempel 1 wird herangeführt, wie durch den Umrisspfeil angedeutet, um im in Fig. 2 dargestellten Prägeschritt die Resistbeschichtung 2 zwischen dem Träger 3 und der strukturierten Oberfläche des Stempels 1 zu prägen. Es verbleibt eine Restdicke 4 zwischen der tiefsten Einprägung und dem Träger 3. Zur Verringerung der Schichtdicke der Resistbeschichtung 2 des Trägers 3, werden in dem in Fig. 3 dargestellten Trennschritt der Stempel 1 von dem Träger 3 getrennt. Dabei haftet ein erster Teil der strukturierten Resistbeschichtung 2a an dem Stempel 1, während ein zweiter, unstrukturierter Teil 2b auf dem Träger 3 zurückbleibt. Durch den Trennschritt ist die Dicke und insbesondere die Restdicke 5 des ersten, auf dem Stempel 1 befindlichen Teils 2a gegenüber dem Zustand beim Prägeschritt verringert. In Fig. 4 wird durch Annäherung des Stempels 1 mit dem ersten Teil 2a der Resistbeschichtung an ein Substrat 6 und Andrücken des Teils 2a auf dessen Oberfläche der erste Teil 2a der Resistbeschichtung auf das Substrat 6 übertragen. Wie in Fig. 4 gezeigt, wird ein Härteschritt durchgeführt, bei dem der erste Teil 2a der Resistbeschichtung mittels UV-Licht-Bestrahlung 7 gehärtet wird. Dazu kann beispielsweise der Stempel 1 aus UV-Licht durchlässigem Polymer hergestellt sein. Im nachfolgenden, in Fig. 6 gezeigten Entformungsschritt wird der Stempel 1 aus dem ersten Teil 2a der gehärteten Resistbeschichtung entfernt, wodurch das Substrat 6 eine strukturierte Resistbeschichtung 2a erhält, die als Maske für einen nachfolgende Ätzbearbeitung (nicht dargestellt) dient, um die Struktur in die Oberfläche des Substrats 6 zu übertragen.

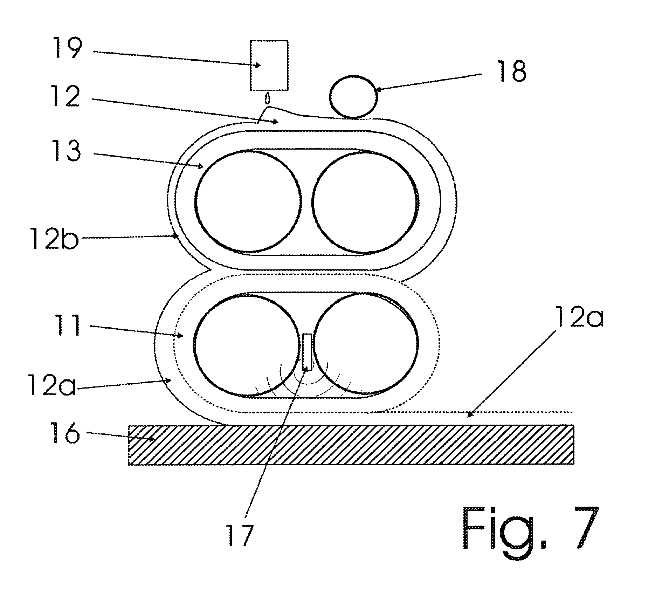

In Fig. 7 ist eine Vorrichtung zur Durchführung des erfindungsgemäßen Verfahrens in einer weiteren Ausführungsform gezeigt. Hierbei handelt es sich um ein Transferverfahren, bei dem der Stempel 11 und der Träger 13 als jeweils auf einem Walzenpaar geführtes und umlaufendes, endloses Transportband ausgestaltet sind. Mittels einer Dispensiervorrichtung 19 wird der fließfähige Resist 12 auf das Träger-Transportband 13 aufgebracht und mittels einer Egalisierwalze 18 wird die Resistbeschichtung des Trägers 13 auf konstante Dicke eingestellt. Auf der gegenüberliegenden Seite des Träger-Transportbandes 13 wird die Resistbeschichtung 12 durch ein als Transportband ausgestalteten Stempel 11 geprägt, der eine angedeutete strukturierte Oberfläche aufweist. Im Auslaufbereich des Berühr- bzw. Prägebereich beider Transportbänder bleibt die Resistbeschichtung 12 nur teilweise auf dem Stempel-Transportband 11 haften. Ein zweiter Teil 12b wird mit dem Träger-Transportband 13 mitgerissen. Ein erster Teil 12a mit der durch die strukturierte Oberfläche des Stempels 11 geprägten Oberfläche wird in einem Berührabschnitt des Transportbandes auf eine Oberfläche des Substrats 16 übertragen, das parallel zum Stempel-Transportband 11 bewegt wird. Gleichzeitig erfolgt eine Aushärtung de Resistbeschichtung durch UV-Bestrahlung eine UV-Lampe 17. Dazu ist das Material des Stempel-Transportbandes 11 aus für UV-Strahlung durchlässigem, flexiblem Polymermaterial hergestellt. Nach dem Aushärten haftet der erste Teil 12a der strukturierten Resistbeschichtung auf dem Substrat 16 und es kommt zur Entformung des Stempel-Transportbandes 11 in dessen Auslaufbereich. Mit der zuvor beschriebenen Vorrichtung kann das erfindungsgemäße Verfahren kontinuierlich durchgeführt werden.

## Patentansprüche

1. Verfahren zur Aufbringung einer strukturierten Beschichtung aus Resist (2a, 12a) auf eine Oberfläche eines Substrats (6, 16) umfassend:
wenigstens einen Schritt, bei dem fließfähiges Resist (2, 12) jeweils zwischen einer strukturierten Oberfläche eines Stempels (1, 11) und einem Träger (3, 13) angeordnet wird, um die Stempeloberfläche mit einer strukturierten Resistbeschichtung (2, 12) zu versehen,
einen jeweils nachfolgenden Trennschritt, bei dem der Stempel mit einem ersten Teil (2a, 12a) der strukturierten Resistbeschichtung und der Träger mit einem zweiten Teil (2b, 12b) der Resistbeschichtung voneinander getrennt werden;
einen nachfolgenden Transferschritt, bei dem der erste Teil (2a, 12a) der strukturierten Resistbeschichtung auf der Oberfläche des Stempels (1, 11) gegen die Oberfläche des Substrats (6, 16) gedrückt wird, um die strukturierte Resistbeschichtung (2a, 12a) auf die Oberfläche des Substrats (6, 16) zu übertragen;
einen Härteschritt, bei dem der erste Teil (2a, 12a) der strukturierten Resistbeschichtung (2a, 12a) ausgehärtet wird;
einen Entformungsschritt, bei dem der Stempel (1, 11) von dem ersten Teil (2a, 12a) der strukturierten Resistbeschichtung getrennt wird,
**dadurch gekennzeichnet, dass** der wenigstens eine Schritt als Prägeschritt durchgeführt wird, bei dem fließfähiges Resist (2, 12) jeweils zwischen einer strukturierten Oberfläche des Stempels (1, 11) und des Trägers (3, 13) geprägt wird, und dass in einem dem Prägeschritt vorgeschalteten Beschichtungsschritt der Träger (3, 13) entweder
- im Schleuderverfahren mit dem fließfähigen Resist (2, 12) beschichtet wird oder
- in einem Transferverfahren, bei dem der Stempel (11) und der Träger (13) jeweils als ein Transportband ausgestaltet sind, mittels einer Dispensiervorrichtung (19) der fließfähige Resist (12) auf den Träger (13) aufgebracht und mittels einer Egalisierwalze (18) die Resistbeschichtung des Trägers (13) auf konstante Dicke eingestellt wird.

2. Verfahren gemäß Anspruch 1, bei dem der Prägeschritt und der jeweils zugehörige Trennschritt mehrfach durchgeführt werden.

3. Verfahren gemäß einem der vorhergehenden Ansprüche, bei dem der Prägeschritt und der jeweils zugehörige Trennschritt mehrfach durchgeführt werden, bis die Restdicke des auf dem Stempel befindlichen ersten Teils der Resistbeschichtung sukzessive auf das gewünschte Maß verringert ist.

4. Verfahren gemäß Anspruch 1, bei dem ein nicht planares Substrat verwendet wird.

5. Verfahren gemäß einem der vorhergehenden Ansprüche, bei dem nach dem Trennschritt der erste Teil (2a, 12a) der Resistbeschichtung mit einem Lösungsmittel benetzt wird.

6. Verfahren gemäß einem der vorhergehenden Ansprüche, bei dem nach dem Trennschritt in einem Schleuderschritt der Stempel mit dem ersten Teil (2a, 12a) der strukturierten Resistbeschichtung geschleudert wird.

7. Verfahren gemäß einem der vorhergehenden Ansprüche, wobei in dem Härteschritt der erste Teil (2a, 12a) der Resistbeschichtung mittels UV-Licht (7, 17) gehärtet wird.

8. Verfahren gemäß einem der vorhergehenden Ansprüche, wobei der Härteschritt und der Transferschritt gleichzeitig oder zeitlich überlappend durchgeführt werden.

9. Verfahren gemäß einem der vorhergehenden Ansprüche, wobei die Struktur der strukturierten Oberfläche des Stempels (1, 11) eine Mikro- bis Nanostruktur ist.

10. Verfahren gemäß einem der vorhergehenden Ansprüche, wobei das Material des Substrats (6, 16) aus der Gruppe bestehend aus wenigstens einem Halbleiter, wie Silizium, GaAs, InP, wenigstens einem Dielektrikum, wie Quarzglas und wenigstens einem Metall und Kombinationen daraus ausgewählt ist.

11. Verfahren gemäß einem der vorhergehenden Ansprüche, wobei das Resist (2, 2a, 2b, 12, 12a, 12b) ein Polymer oder Monomer, bevorzugt ein rein-organisches Monomer oder ein organisches/anorganisches Verbundmonomer ist.

12. Verfahren gemäß einem der vorhergehenden Ansprüche, wobei der Stempel (1, 11) flexibel ist.

13. Verfahren gemäß einem der vorhergehenden Ansprüche, wobei der Stempel (1, 11) aus einem Polymer hergestellt ist.

14. Verfahren gemäß einem der vorhergehenden Ansprüche, wobei der Träger (13) und/oder der Stempel (11) als Walze oder Transportband ausgebildet sind.

15. Verfahren gemäß dem vorhergehenden Anspruch, wobei der Träger (13) und der Stempel (11) als Walze oder Transportband ausgebildet sind und der wenigstens eine Prägeschritt mit zugehörigem Trennschritt, der Druckschritt und Entformungsschritt in einem kontinuierlichen Walzenach-Walze-Transferverfahren durchgeführt werden.

16. Verfahren gemäß einem der vorhergehenden Ansprüche, wobei gegenüberliegende Oberflächen des Substrats (6, 16) gleichzeitig dem Transferschritt unterzogen werden.

17. Verfahren gemäß einem der vorhergehenden Ansprüche, wobei in einem dem Entformungsschritt nachfolgenden Ätzschritt und optionalen Dotierschritt die mit der strukturierten Resistoberfläche (2a, 12a) beschichtete Oberfläche des Substrats (6, 16) geätzt und optional dotiert wird.

18. Verwendung des Verfahrens gemäß dem vorhergehenden Anspruch zur Herstellung einer Halbleiterstruktur.

## Claims

1. Method for applying a patterned coating of resist (2a, 12a) onto a surface of a substrate (6, 16), comprising:
at least one step wherein flowable resist (2, 12) is respectively disposed between a patterned surface of a stamp (1, 11) and a carrier (3, 13) in order to provide the stamp surface with a patterned resist surface (2, 12),
a respectively subsequent separation step, wherein the stamp with a first part (2a, 12a) of the patterned resist coating and the carrier with a second part (2b, 12b) of the resist coating are separated from each other;
a subsequent transfer step, wherein the first part (2a, 12a) of the patterned resist coating on the surface of the stamp (1, 11) is pressed against the surface of the substrate (6, 16) in order to transfer the patterned resist coating (2a, 12a) onto the surface of the substrate (6, 16);
a curing step, wherein the first part (2a, 12a) of the patterned resist coating (2a, 12a) is cured;
a demoulding step, wherein the stamp (1, 11) is separated from the first part (2a, 12a) of the patterned resist coating,
**characterised in that** the at least one step is carried out as an embossing step, wherein flowable resist (2, 12) is respectively embossed between a patterned surface of the stamp (1, 11) and the carrier (3, 13), and that, in a coating step preceding the embossing step, the carrier (3, 13) is either
- coated with the flowable resist (2, 12) by means of the spin coating process, or
- in a transfer process in which the stamp (11) and the carrier (13) are respectively configured as a conveyor belt, the flowable resist (12) is applied to the carrier (13) by means of a dispensing device (19) and the resist coating of the carrier (13) is set to a constant thickness by means of an evener roll (18).

2. Method according to claim 1, wherein the embossing step and the respectively associated separation step are carried out several times.

3. Method according to any one of the preceding claims, wherein the embossing step and the respectively associated separation step are carried out several times until the residual thickness of the first part of the resist coating located on the stamp has been successively reduced to the desired measure.

4. Method according to claim 1, wherein a non-planar substrate is used.

5. Method according to any one of the preceding claims, wherein, after the separation step, the first part (2a, 12a) of the resist coating is wetted with a solvent.

6. Method according to any one of the preceding claims, wherein, after the separation step, the stamp with the first part (2a, 12a) of the patterned resist coating is spun in a spinning step.

7. Method according to any one of the preceding claims, wherein, in the curing step, the first part (2a, 12a) of the resist coating is cured by means of ultraviolet light (7, 17).

8. Method according to any one of the preceding claims, wherein the curing step and the transfer step are carried out simultaneously or overlapping in time.

9. Method according to any one of the preceding claims, wherein the pattern of the patterned surface of the stamp (1, 11) is a micropattern to nanopattern.

10. Method according to any one of the preceding claims, wherein the material of the substrate (6, 16) is selected from the group consisting of at least one semiconductor, such as silicon, GaAs, InP, at least one dielectric, such as quartz glass, and at least one metal and combinations thereof.

11. Method according to any one of the preceding claims, wherein the resist (2, 2a, 2b, 12, 12a, 12b) is a polymer or monomer, preferably a purely organic monomer or an organic/inorganic composite monomer.

12. Method according to any one of the preceding claims, wherein the stamp (1, 11) is flexible.

13. Method according to any one of the preceding claims, wherein the stamp (1, 11) is made from a polymer.

14. Method according to any one of the preceding claims, wherein the carrier (13) and/or the stamp (11) are configured as a roll or conveyor belt.

15. Method according to the preceding claim, wherein the carrier (13) and the stamp (11) are configured as a roll or conveyor belt, and the at least one embossing step with the associated separation step, the pressing step and the demoulding step are carried out in a continuous roll-after-roll process.

16. Method according to any one of the preceding claims, wherein opposite surfaces of the substrate (6, 16) are simultaneously subjected to the transfer step.

17. Method according to any one of the preceding claims, wherein the surface of the substrate (6, 16) coated with the patterned resist surface (2a, 12a) is etched and optionally doped in an etching step and an optional doping step following the demoulding step.

18. Use of the method according to the preceding claim for producing a semiconductor pattern.

## Revendications

1. Procédé d'application d'un revêtement structuré en résiste (2a, 12a) sur une surface d'un substrat (6, 16), comprenant :
au moins une étape dans laquelle du résiste (2, 12) apte à couler est disposé respectivement entre une surface structurée d'un poinçon (1, 11) et un support (3, 13) afin de pourvoir la surface du poinçon d'un revêtement de résiste (2, 12) structuré,
une étape de séparation respectivement suivante dans laquelle ledit poinçon avec une première partie (2a, 12a) du revêtement de résiste structuré et le support avec une deuxième partie (2b, 12b) du revêtement de résiste sont séparés l'un de l'autre,
une étape de transfert suivante dans laquelle ladite première partie (2a, 12a) du revêtement de résiste structuré sur la surface du poinçon (1, 11) est pressée contre la surface du substrat (6, 16) afin de transférer le revêtement de résiste structuré (2a, 12a) à la surface du substrat (6, 16),
une étape de durcissement dans laquelle la première partie (2a, 12a) du revêtement de résiste structuré est durcie,
une étape de démoulage dans laquelle ledit poinçon (1, 11) est séparé de la première partie (2a, 12a) du revêtement de résiste structuré,
**caractérisé par le fait que** ladite au moins une étape est mise en oeuvre comme étape d'estampage dans laquelle du résiste (2, 12) apte à couler est estampé respectivement entre une surface structurée du poinçon (1, 11) et du support (3, 13), et que, dans une étape de revêtement réalisée en amont de l'étape d'estampage, ledit support (3, 13),
- soit, est revêtu du résiste (2, 12) apte à couler dans un procédé de centrifugation,
- soit, dans un procédé de transfert dans lequel ledit poinçon (11) et ledit support (13) sont réalisés chacun sous forme d'une bande transporteuse, le résiste (12) apte à couler est appliqué au moyen d'un dispositif à dispenser (19) sur ledit support (13) et le revêtement de résiste du support (13) est réglé au moyen d'un rouleau égalisateur (18) de manière à présenter une épaisseur constante.

2. Procédé selon la revendication 1, dans lequel ladite étape d'estampage et l'étape de séparation respectivement associée sont mises en oeuvre à plusieurs reprises.

3. Procédé selon l'une quelconque des revendications précédentes, dans lequel ladite étape d'estampage et l'étape de séparation respectivement associée sont mises en oeuvre à plusieurs reprises jusqu'à ce que l'épaisseur restante de la première partie du revêtement de résiste, présente sur ledit poinçon soit réduite successivement à la mesure souhaitée.

4. Procédé selon la revendication 1, dans lequel on utilise un substrat non planaire.

5. Procédé selon l'une quelconque des revendications précédentes, dans lequel, après ladite étape de séparation, la première partie (2a, 12a) du revêtement de résiste est mouillée d'un solvant.

6. Procédé selon l'une quelconque des revendications précédentes, dans lequel, après ladite étape de séparation, ledit poinçon avec ladite première partie (2a, 12a) du revêtement de résiste structuré est centrifugé dans une étape de centrifugation.

7. Procédé selon l'une quelconque des revendications précédentes, dans lequel, dans ladite étape de durcissement, la première partie (2a, 12a) du revêtement de résiste est durcie au moyen d'une lumière UV (7, 17).

8. Procédé selon l'une quelconque des revendications précédentes, dans lequel ladite étape de durcissement et ladite étape de transfert sont mises en oeuvre simultanément ou de manière à se recouvrir temporellement.

9. Procédé selon l'une quelconque des revendications précédentes, dans lequel la structure de la surface structurée du poinçon (1, 11) est une micro- à nanostructure.

10. Procédé selon l'une quelconque des revendications précédentes, dans lequel le matériau du substrat (6, 16) est choisi dans le groupe comprenant au moins un semi-conducteur, tel que le silicium, GaAs, InP, au moins un diélectrique, tel que le verre de quartz, et au moins un métal et des combinaisons de ceux-ci.

11. Procédé selon l'une quelconque des revendications précédentes, dans lequel ledit résiste (2, 2a, 2b, 12, 12a, 12b) est un polymère ou monomère, de préférence un monomère purement organique ou un monomère composite organique/inorganique.

12. Procédé selon l'une quelconque des revendications précédentes, dans lequel ledit poinçon (1, 11) est flexible.

13. Procédé selon l'une quelconque des revendications précédentes, dans lequel le poinçon (1, 11) est réalisé dans un polymère.

14. Procédé selon l'une quelconque des revendications précédentes, dans lequel ledit support (13) et/ou ledit poinçon (11) sont réalisés en tant que rouleau ou bande transporteuse.

15. Procédé selon la revendication précédente, dans lequel ledit support (13) et ledit poinçon (11) sont réalisés en tant que rouleau ou bande transporteuse et que ladite au moins une étape d'estampage avec l'étape de séparation associée, ladite étape d'impression et ladite étape de démoulage sont mises en oeuvre dans un procédé continu de transfert de rouleau à rouleau.

16. Procédé selon l'une quelconque des revendications précédentes, dans lequel des surfaces du substrat (6, 16) qui sont situées en vis-à-vis sont soumises simultanément à l'étape de transfert.

17. Procédé selon l'une quelconque des revendications précédentes, dans lequel, dans une étape de gravure qui suit ladite étape de démoulage et dans une étape optionnelle de dopage, la surface du substrat (6, 16) qui est revêtue de la surface de résiste structurée (2a, 12a) est gravée et, optionnellement, dopée.

18. Utilisation du procédé selon la revendication précédente, pour la fabrication d'une structure semi-conductrice.
